# EUROPÄISCHE PATENTSCHRIFT

(11) **EP 1 072 181 B1**
(45) Veröffentlichungstag und Bekanntmachung des Hinweises auf die Patenterteilung: **08.10.2003**
(21) Anmeldenummer: 99919122.4
(22) Anmeldetag: 25.03.1999
(51) Int. Cl.: H05K 13/04

(54) **BESTÜCKVORRICHTUNG ZUM BESTÜCKEN VON BAUELEMENTETRÄGERN**
DEVICE FOR MOUNTING COMPONENTS ON COMPONENT SUPPORTS
DISPOSITIF DE MISE EN PLACE DE SUPPORTS DE COMPOSANTS

(30) Priorität: 09.04.1998 DE 19816134
(43) Veröffentlichungstag der Anmeldung: 31.01.2001
(73) Patentinhaber: SIEMENS AKTIENGESELLSCHAFT, 80333 München (DE)
(72) Erfinder: DREXEL, Peter, D-82194 Gröbenzell (DE)
(86) Internationale Anmeldenummer: DE9900893
(87) Internationale Veröffentlichungsnummer: WO99053741

(56) Entgegenhaltungen:
- EP-A- 0 315 799
- US-A- 4 706 379
- US-A- 5 313 401

## Beschreibung

Die Erfindung bezieht sich auf eine Bestückvorrichtung zum Bestücken von Bauelementeträgern mit elektrischen Bauelementen mittels eines Bestückkopfes, der aus einem relativ zum Bauelementeträger und zumindest einem an diesem beweglich gelagerten Halter für eine Vielzahl von Greifern für die Bauelemente besteht.

Eine derartige Bestückvorrichtung ist z.B. durch die EP-C 0 315 799 bekannt geworden. Der Bestückkopf ist hier als Revolverkopf ausgebildet, bei dem ein in zwei Koordinatenrichtungen verfahrbarer Träger mehrere Bearbeitungsstationen für die Bauelemente aufweist. Am Träger ist ein Halter für eine Vielzahl von sternförmig angeordneten Saugpipetten drehbar gelagert. Die Saugpipetten werden zunächst mit Bauelementen versehen. Bei der schrittweisen Antriebsdrehung des Halters werden die Bauelemente an verschiedenen Bearbeitungsstationen vorbeigeführt. Eine der Bearbeitungsstationen ist z.B. eine Optikstation zur Lageerkennung der Bauelemente an den Pipetten. In einer nachfolgenden Station werden die Bauelemente in ihre genaue Einbaulage verdreht. Zum Aufsetzen auf die Leiterplatte werden die Saugpipetten sukzessive in eine zur Leiterplatte senkrechte Stellung verdreht. Der Träger ist neben den Bearbeitungsstationen mit einem Verschiebeantrieb versehen, der jeweils auf die aufzusetzende Saugpipette einwirkt und diese zur Leiterplatte hin absenkt.

Der Erfindung liegt die Aufgabe zugrunde, die Bestückleistung der Bestückvorrichtung zu erhöhen.

Diese Aufgabe wird durch die Erfindung gemäß Anspruch 1 gelöst. Bei der bekannten Bestückvorrichtung konnte mittels des Verschiebeantriebs jeweils nur ein einziger Greifer betätigt werden. Durch die Zuordnung des Verschiebeantriebes zum nichtdrehbaren Träger waren die gestalterischen Möglichkeiten, insbesondere im Hinblick auf die Erhöhung der Greiferzahl begrenzt.

Durch die erfindungsgemäße Zuordnung des Verschiebeantriebs zu jedem der Greifer ist es möglich, die Greifer in unterschiedlicher Konfiguration anzuordnen und an die verschiedenen Funktionen der Bestückvorrichtung anzupassen. Dadurch kann die Bestückleistung entsprechend erhöht werden.

Vorteilhafte Weiterbildungen der Erfindung sind in den Unteransprüchen gekennenzeichnet.

Durch die Weiterbildung nach Anspruch 2 kann auf eine am Träger befestigte Verdrehstation verzichtet werden. Es ist möglich, den Verschiebeantrieb und den Verdrehantrieb nach Anspruch 3 in einer kombinierten Anspruchseinheit zusammenzufassen. Derartige Antriebseinheiten sind z.B. als kombinierte Dreh-Hub-Antriebe bekannt, bei denen die Drehbewegung mittels zirkulär verteilter Magnete erzeugt wird und die Hubbewegung durch mehrere axial hintereinanderliegende Magnetringe in der Art eines Linearmotors durchgeführt werden kann. Eine derartige Antriebseinheit kann kompakt und leicht ausgebildet werden, was den Einbau in den Bestückkopf erleichtert.

Der Bestückkopf nach dem Stand der Technik weist nur eine Reihe von Saugpipetten auf. Eine mehrreihige Lösung ist hier nicht möglich, da der stationäre Verschiebeantrieb aus konstruktiven Gründen nur eine Greiferreihe bedienen kann. Durch den autonomen Greiferantrieb können die Greifer in mehreren Reihen angeordnet werden, wodurch die Bestückleistung entsprechend erhöht wird.

Durch die Weiterbildungen nach den Ansprüchen 5 und 6 können mehrere Greiferreihen von den Bearbeitungsstationen bedient werden. Derartige Bearbeitungsstationen sind z.B. am Umfang des Halters angebracht und können daher ohne Probleme am nicht drehbaren Träger des Bestückkopfes befestigt werden.

Werden die Greiferreihen in engem Abstand zueinander angeordnet, so können beide Reihen nach Anspruch 7 z.B. von einer Kamera erfaßt werden.

Durch die revolverartige Ausbildung des Halters nach Anspruch 8 ist es möglich, die Greifer genau zu führen und in verschiedenen Winkelstellungen zu fixieren.

Durch die Weiterbildung nach Anspruch 9 kann der Bestückkopf in verschiedene Bereiche der Bestückvorrichtung verfahren werden, um z.B. Bauelemente aufzunehmen und zum Bauelementeträger zu transportieren. Andere Funktionen bestehen z.B. darin, daß der Bestückkopf zu einem Wechselmagazin für Saugpipetten verfahren wird, um geeignete Saugpipetten aufzunehmen. Ein besonderer Vorteil besteht darin, daß der Bestückkopf im Zuführbereich zunächst sämtliche Greifer mit Bauelementen versieht, sodann über den Bauelementeträger verfährt und die Bauelemente sukzessive absetzt.

Die Weiterbildungen nach den Ansprüche 10 und 11 ermöglichen ohneweiteres eine mehrreihige Anordnung der Greifer und eine entsprechende Leistungssteigerung.

Bei den Weiterbildungen nach den Ansprüchen 12 und 13 dreht sich der Halter flach über dem Bauelementeträger und überdeckt so einen größeren Teil des Bestückbereiches. Dadurch ist es möglich, einen Teil der Transportbewegungen mittels der Drehbewegung des Halters durchzuführen. Das bedeutet, daß z.B. die Verfahrwege zwischen den Bauelementezuführungen und dem Bestückbereich kleiner gehalten werden können.

Durch die Weiterbildung nach Anspruch 14 ist es möglich, die quer zur Verfahrrichtung liegenden Positionsabstände mittels der Drehbewegung auszuführen. Dabei wird der jeweilige Greifer in eine dem Seitenabstand entsprechende Winkelstellung verfahren, wobei der Bestückkopf durch einen entsprechenden überlagernden Verfahrweg die Längskomponente des Verdrehwinkels kompensiert. Die Winkelstellung der Bauelemente muß beim Verdrehvorgang ebenfalls um die Winkelstellung des Halters korrigiert werden, um eine entsprechende Drehlage einzunehmen. Der besondere Vorteil besteht darin, daß hierbei eine Kreuzführung des Bestückkopfes mit einem verfahrbaren Arm vermieden wird.

Bei der Weiterbildung nach Anspruch 15 können die Greifer in eine dem seitlichen Abstand der Abholpostionen entsprechende Drehstellung verfahren werden, so daß auch hier ein großer Teil der Transportwege durch eine Drehbewegung des Halters ausgeführt werden kann. Nachdem sämtliche Greifer mit Bauelementen belegt sind, kann der Bestückkopf in einer einfachen geradlinigen Bewegung in den Bestückbereich der Bestückvorrichtung zurückverfahren werden.

Durch die Weiterbildung nach Anspruch 16 ist es möglich, die Bestückleistung dadurch zu erhöhen, daß z.B. die Bestückköpfe abwechselnd bestücken bzw. Bauteile aufnehmen. Dabei ist es von Vorteil, die Zuführungen zu beiden Seiten der Leiterplatte anzuordnen, so daß die Bestückköpfe einander jeweils problemlos ausweichen können. Es ist aber möglich, eine größere Anzahl von Bestückköpfen zu verwenden, die jeweils einen Teilbereich des Bestückbereiches überdecken. Ferner ist es möglich, im Bestückbereich mehrere Leiterplatten anzuordnen, die von einer entsprechend großen Anzahl von Bestückköpfen bedient werden.

Durch die Weiterbildung nach Anspruch 17 wird der Antriebsund Führungsaufwand für die beiden Bestückköpfe erheblich verringert. Das Antriebssystem kann z.B. als Linearmotor ausgebildet sein, auf dem die beiden Bestückköpfe unabhängig voneinander verfahrbar sind.

Im folgenden wird die Erfindung anhand von in der Zeichnung dargestellten Ausführungsbeispielen näher erläutert.
- Figur 1: zeigt eine Seitenansicht eines Bestückkopfes einer Bestückvorrichtung mit einem Bauelementeträger,
- Figur 2: eine andere Seitansicht des Bestückkopfes nach Figur 1,
- Figur 3: eine Seitenansicht eines anderen Bestückkopfes einer anderen Bestückvorrichtung mit dem Bauelementeträger,
- Figur 4: eine Draufsicht auf die Teile nach Figur 3,
- Figur 5: einen Teil einer anderen Bestückvorrichtung ähnlich Figur 4 mit zwei Bestückköpfen in einer Linearführung.

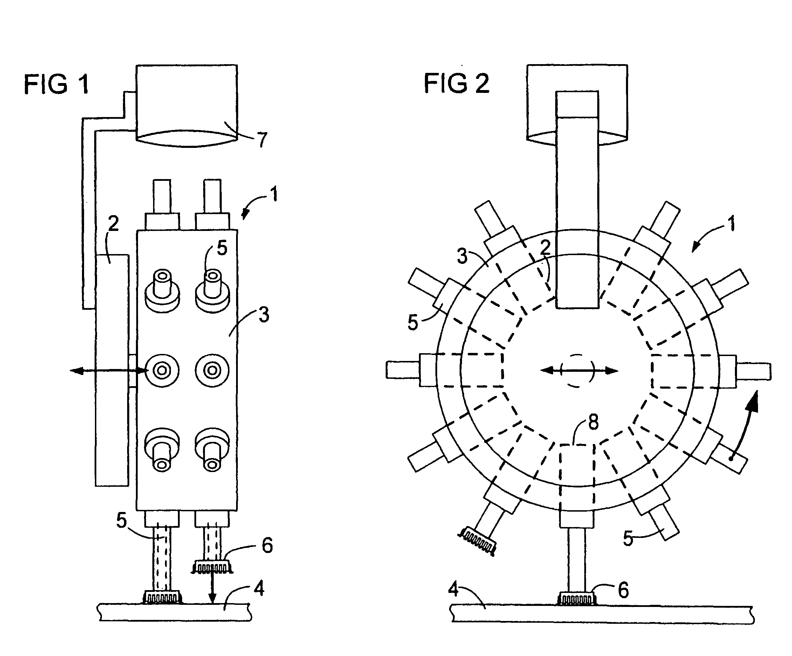

Nach den Figuren 1 und 2 ist ein gemäß den waagerechten Pfeilen in zwei Koordinatenrichtungen verfahrbarer Bestückkopf 1 mit einem Träger 2 versehen, an dem ein Halter 3 um eine waagerechte Achse drehbar gelagert ist. Unterhalb des Halters 3 befindet sich ein z.B. als Leiterplatte ausgebildeter waagerecht liegender Bauelementeträger 4. Der Halter 3 ist mit sternförmig verteilten, radial abstehenden Greifern 5 versehen, die als Saugpipetten ausgebildet sind, an denen elektrische Bauelemente 6 angesaugt sind. Der Halter weist zwei axial hintereinanderliegende Reihen der Greifer 5 auf. Eine Optikstation 7 ist am Trager 2 befestigt und auf die freien Enden eines der Greiferpaare gerichtet. Sie dient der genauen Lageerkennung von Bauelementen die durch den schrittweisen Drehantrieb des Halters 3 in das Sichtfeld der Optikstation 7 gebracht werden.

Der Bauelementeträger 4 befindet sich unterhalb einer Aufsetzstellung des Halters 3. In dieser Stellung ist der jeweilige Greifer 5 auf den Bauelementeträger 4 mittels eines Verschiebeantriebes 8 absenkbar, wodurch das jeweilige Bauelement 6 auf den Bauelementeträger 4 aufgesetzt werden kann. Der Halter 3 weist für jeden der Greifer 5 einen eigenen Verschiebeantrieb 8 auf. Dadurch ist es möglich, eine größere Anzahl von Greiferreihen im Halter 3 vorzusehen und die Bestückleistung entsprechend zu erhöhen.

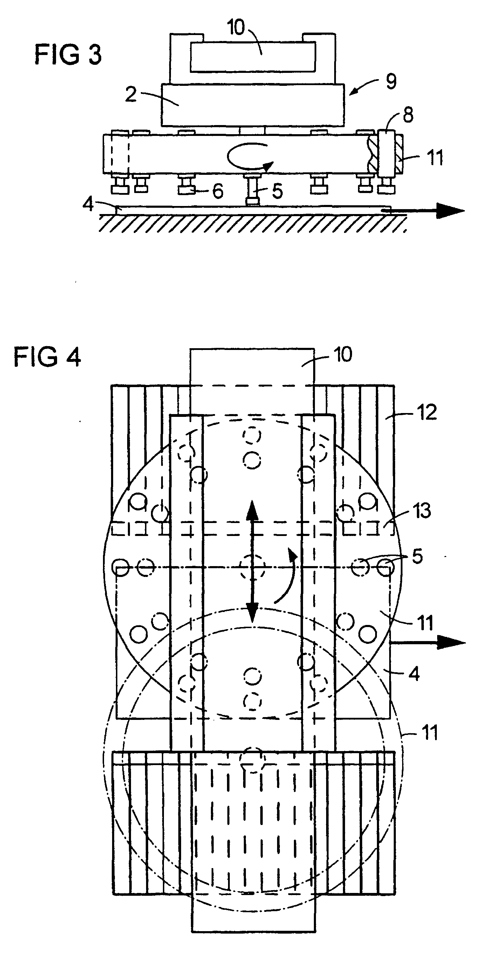

Nach den Figuren 3 und 4 ist der Halter 2 eines anderen Bestückkopfes 9 in einer an der Bestückvorrichtung feststehenden Linearführung 10 in einer Koordinatenrichtung verfahrbar. Die Drehachse des Bestückkopfes 9 ist hierbei senkrecht zum Bauelementeträger 4 gerichtet. Ein Halter 10 weist zylindrisch verteilte Greifer 5 auf, die ebenfalls senkrecht zum Bauelementeträger 4 angeordnet sind. Auch hier ist jedem der Greifer 5 ein eigener Verschiebeantrieb 8 zugeordnet.

Es ist möglich, den Halter 11 mit einer zweiten Reihe von ringförmig verteilten Greifern zu versehen, wie dies durch die strichpunktierten Kreise angedeutet ist.

Der Teilkreisdurchmesser der Greifer 5 ist so groß bemessen, daß er den Bauelementeträger 4 in seiner vollen Breite überdeckt. Durch Verdrehen des jeweiligen Greifers 5 in eine geeignete Winkelstellung ist es möglich, die Bauelemente 6 in unterschiedlichem Abstand zur Linearführung auf den Bauelementeträger 4 aufzusetzen, wobei die andere Koordinatenrichtung durch einen entsprechenden Verfahrweg entlang der Linearführung 10 eingestellt wird. Die Winkelstellung der Bauelemente 6 ist durch einen Drehantrieb der Greifer 5 veränderbar, wobei jedem der Greifer 5 ein eigener Drehantrieb zugeordnet ist, der mit dem Verschiebeantrieb 8 zu einer Baueinheit zusammengefaßt ist. Die Winkelstellung des Halters 11 ist derart feinstufig einstellbar, daß die Bauelemente 6 in beliebigem Aeitenabstand zur Linearführung auf den Bauelementeträger aufgesetzt werden können.

Zu beiden Seiten des Bauelementeträgers 4 sind unter der Linearführung 10 Bauelementezuführungen 12 angeordnet über die der Bestückkopf 9 verfahrbar ist. Die Bauelementezuführungen 12 sind quer zur Linearführung in einer Breite aneinandergereiht, die noch vom Bestückkopf 9 überdeckt ist. In ähnlicher Weise wie beim Aufsetzen der Bauelemente 6 kann auch hier durch unterschiedliche Winkelstellungen des Halters (11) und eine entsprechende Verfahrbewegung des Bestückkopfes 9 entlang der Linearführung 10 einer der Greifer 5 jeweils über eine Entnahmestelle 13 der Bauelementezuführungen 12 gebracht werden. Durch den Verschiebeantrieb 8 ist dann der Greifer soweit auf das Bauelement 6 absenkbar, sodaß dieses aus der Bauelementezuführung 12 entnommen werden kann.

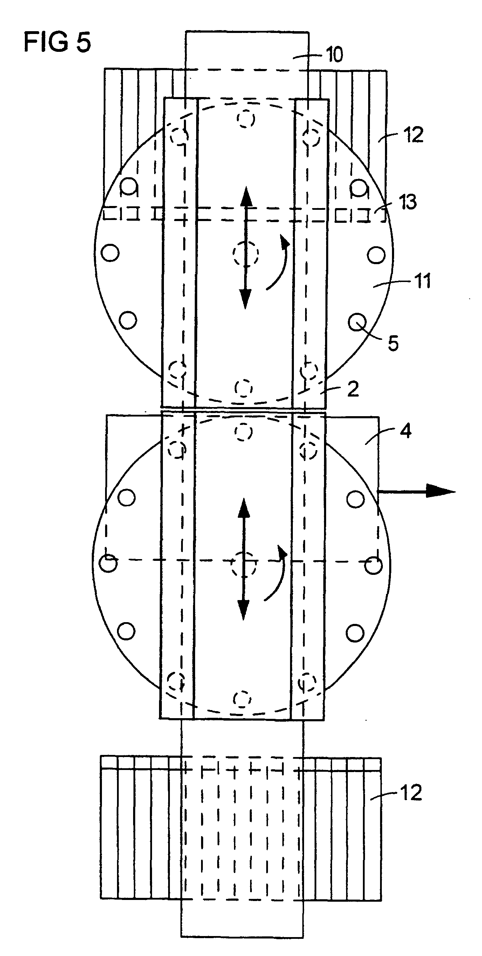

Figur 5 zeigt eine abgewandelte Version der Bestückvorrichtung nach Figur 4, wobei in der gestreckten Linearführung 10 zwei hintereinanderliegende Bestückköpfe 9 geführt und unabhängig voneinander angetrieben sind. Die beiden Bestückköpfe 9 können jeweils eine Gruppe der Entnahmestellen 13 der Bauelementezuführungen erreichen und soweit über den Bauelementeträger 4 verfahren werden, daß jeder der Greifer 5 an jeder Aufsetzposition des Bauelementeträgers 4 positioniert werden kann. Bei dieser Anordnung können die Bestückköpfe 9 abwechselnd Bauteile 6 abholen und aufsetzen, so daß die Bestückleistung entsprechend gesteigert werden kann.

## Patentansprüche

1. Bestückvorrichtung zum Bestücken von Bauelementeträgern (4) mit elektrischen Bauelementen (6) mittels zumindest eines Bestückkopfes, der aus einem relativ zum Bauelementeträger (4) verfahrbaren Träger (2) und zumindest einem an diesem beweglich gelagerten Halter (3) für eine Vielzahl von Greifern (5) für die Bauelemente (6) besteht, wobei die Greifer (5) vorzugsweise als Saugpipetten ausgebildet sind,
wobei der Träger (2) zumindest eine Bearbeitungsstation für die Bauelemente (6) aufweist, an der die Greifer (5) vorbeibewegbar sind,
wobei jeder der Greifer (5) in dem Halter (3) um eine eigene Mittelachse drehbar gelagert sind,
wobei zumindest der sich in einer Aufsetzposition befindliche Greifer (5) zum Bauelementeträger (4) entlang seiner Drehachse hin absenkbar und ist und
wobei der Bestückkopf mit Antriebsmitteln zum Verschieben und Verdrehen der Greifer (5) versehen ist,
**dadurch gekennzeichnet,**
**daß** am beweglichen Halter (3) jedem der Greifer (5) ein autonomer, einzeln ansteuerbarer Verschiebeantrieb (8) zum Absenken des Greifers (5) zugeordnet ist.

2. Bestückvorrichtung nach Anspruch 1,
**dadurch gekennzeichnet,**
**daß** jedem der Greifer (5) ein eigener Verdrehantrieb zugeordnet ist.

3. Bestückvorrichtung nach Anspruch 2,
**dadurch gekennzeichnet,**
**daß** der Verschiebeantrieb (8) und der Verdrehantrieb in einer kombinierten Antriebseinheit zusammengefaßt sind, die eine Vielzahl von konzentrisch verteilten Magneten aufweist, die in mehreren axial übereinanderliegenden Ringen angeordnet sind.

4. Bestückvorrichtung nach einem der Ansprüche 1 - 3,
**dadurch gekennzeichnet,**
**daß** die Greifer (5) am Halter (3) in Bezug auf ihre Relativbewegung zum Träger (2) mehrreihig angeordnet sind.

5. Bestückvorrichtung nach Anspruch 4,
**dadurch gekennzeichnet,**
**daß** jeder der Reihen zumindest eine der Bearbeitungsstationen (z.B. 7) zugeordnet ist.

6. Bestückvorrichtung nach Anspruch 4,
**dadurch gekennzeichnet,**
**daß** die Bearbeitungsstation zumindest zwei Greiferreihen erfaßt.

7. Bestückvorrichtung nach Anspruch 6,
**dadurch gekennzeichnet,**
**daß** eine der Bearbeitungsstationen als Optikstation (7) zur Erkennung der Lage der Bauelemente (6) am Greifer (5) ausgebildet ist,
**daß** das Sichtfeld der Optikstation (7) zumindest zwei Greiferreihen überdeckt und
**daß** eine mit der Optikstation (7) verbundene Auswerteeinrichtung die den einzelnen Greiferreihen zugeordneten Sichtbereiche getrennt auswertet.

8. Bestückvorrichtung nach einem der vorhergehenden Ansprüche,
**dadurch gekennzeichnet,**
**daß** der revolverartige Halter (3) am Träger (2) drehbar gelagert ist.

9. Bestückvorrichtung nach Anspruch 8,
**dadurch gekennzeichnet,**
**daß** der Träger (2) an der Bestückvorrichtung in zumindest einer Koordinatenrichtung verfahrbar gelagert ist.

10. Bestückvorrichtung nach Anspruch 9,
**dadurch gekennzeichnet,**
**daß** die Drehachse des Halters (3) parallel zur Aufsetzfläche des Bauelementeträgers (4) gerichtet ist und
**daß** die Greifer (5) in zumindest einer Drehebene am Halter (3) radial abstehend angeordnet sind.

11. Bestückvorrichtung nach Anspruch 9,
**dadurch gekennzeichnet,**
**daß** die Drehachse des Halters schräg zur Aufsetzfläche geneigt ist und
**daß** die Greifer am Halter kegelförmig verteilt angeordnet sind.

12. Bestückvorrichtung nach Anspruch 8 oder 9,
**dadurch gekennzeichnet,**
**daß** die Drehachse des Halters (11) senkrecht zur Aufsetzfläche steht und
**daß** zur Aufsetzfläche senkrecht stehende Greifer (5) am Halter (11) ringförmig verteilt angeordnet sind.

13. Bestückvorrichtung nach Anspruch 12,
**dadurch gekennzeichnet,**
**daß** die Greifer (5) in zumindest zwei Ringen unterschiedlichen Durchmessers angeordnet sind.

14. Bestückvorrichtung nach Anspruch 12 oder 13,.
**dadurch gekennzeichnet,**
**daß** der Durchmesser des äußersten Ringes der Greifer (5) zumindest gleich der Breite eines Bestückbereiches der Bestückvorrichtung ist,
**daß** der Bauelementeträger (4) oder der Bestückkopf (9) an der Bestückvorrichtung senkrecht zu dieser ersten Koordinatenrichtung verschiebbar ist und
**daß** der Halter (3) feinstufig am Träger (2) in eine Winkelstellung verdrehbar ist, in der das jeweilige Bauelement (6) im vorgegebenen ersten Koordinatenabstand auf den Bauelementeträger (4) aufsetzbar ist.

15. Bestückvorrichtung nach Anspruch 14,
**dadurch gekennzeichnet,**
**daß** an der Bestückvorrichtung außerhalb des Bestückbereiches Bauelementezuführungen (12) angeordnet sind, daß der Bauelementeträger (4) temporär in einer definierten Lage an der Bestückvorrichtung fixierbar ist,
**daß** der Bestückkopf (9) zwischen den Bauelementezuführungen(12) und dem Bestückbereich verfahrbar ist und
**daß** Entnahmestellen (13) der Bauelementezuführungen innerhalb des Überdeckungsbereiches der Greifer (5) angeordnet sind.

16. Bestückvorrichtung nach Anspruch 15,
**dadurch gekennzeichnet,**
**daß** die Bestückvorrichtung mit zumindest zwei voneinander unabhängig verfahrbaren Bestückköpfen (9) versehen ist.

17. Bestückvorrichtung nach Anspruch 16,
**dadurch gekennzeichnet,**
**daß** die Bestückköpfe (9) in einem gemeinsamen Antriebs- und Führungssystem verfahrbar sind.

## Claims

1. Device for mounting electrical components (6) on component supports (4) by means of at least one mounting head, which comprises a carrier (2) which can be moved in relation to the component support (4) and at least one holder (3) which is mounted movably on said carrier for a multiplicity of grippers (5) for the components (6), the grippers (5) preferably being designed as suction pipettes, the carrier (2) having at least one processing station for the components (6), past which the grippers (5) can be moved, each of the grippers (5) being mounted rotatably about its own centre axis in the holder (3), at least the gripper (5) located in a placement position being able to be lowered towards the component support (4) along its axis of rotation and the mounting head being provided with driving means for displacing and turning the grippers (5), **characterized in that** on the movable holder (3) each of the grippers (5) is assigned an autonomous, individually activatable displacing drive (8) for lowering the gripper (5).

2. Mounting device according to Claim 1, **characterized in that** each of the grippers (5) is assigned its own turning drive.

3. Mounting device according to Claim 2, **characterized in that** the displacing drive (8) and the turning drive are combined in a combined drive unit which has a multiplicity of concentrically distributed magnets which are arranged in a plurality of rings lying axially one above the other.

4. Mounting device according to one of Claims 1 - 3, **characterized in that** the grippers (5) are arranged in a number of rows on the holder (3) with respect to their relative movement in relation to the carrier (2).

5. Mounting device according to Claim 4, **characterized in that** each of the rows is assigned at least one of the processing stations (e.g. 7).

6. Mounting device according to Claim 4, **characterized in that** the processing station records at least two rows of grippers.

7. Mounting device according to Claim 6, **characterized in that** one of the processing stations is designed as an optics station (7) for detecting the position of the components (6) on the gripper (5), **in that** the field of view of the optics station (7) covers at least two rows of grippers and **in that** an evaluating device connected to the optics station (7) separately evaluates the viewing regions assigned to the individual rows of grippers.

8. Mounting device according to one of the preceding claims, **characterized in that** the turret-like holder (3) is rotatably mounted on the carrier (2).

9. Mounting device according to Claim 8, **characterized in that** the carrier (2) is mounted on the mounting device in such a way that it can be moved in at least one coordinate direction.

10. Mounting device according to Claim 9, **characterized in that** the axis of rotation of the holder (3) is directed parallel to the placement surface of the component support (4) and **in that** the grippers (5) are arranged on the holder (3) in a radially protruding manner in at least one rotational plane.

11. Mounting device according to Claim 9, **characterized in that** the axis of rotation of the holder is inclined obliquely to the placement surface and **in that** the grippers are arranged on the holder in a conically distributed manner.

12. Mounting device according to Claim 8 or 9, **characterized in that** the axis of rotation of the holder (11) is perpendicular to the placement surface and **in that** grippers (5) which are perpendicular to the placement surface are arranged on the holder (11) in an annularly distributed manner.

13. Mounting device according to Claim 12, **characterized in that** the grippers (5) are arranged in at least two rings of different diameters.

14. Mounting device according to Claim 12 or 13, **characterized in that** the diameter of the outermost ring of the grippers (5) is at least equal to the width of a mounting region of the mounting device, **in that** the component support (4) or the mounting head (9) can be displaced on the mounting device perpendicularly to this first coordinate direction and **in that** the holder (3) can be turned in fine stages on the carrier (2) into an angular position in which the respective component (6) can be placed onto the component support (4) at the predetermined first coordinate distance.

15. Mounting device according to Claim 14, **characterized in that** component feeds (12) are arranged on the mounting device outside the mounting region, **in that** the component support (4) can be temporarily fixed on the mounting device in a defined position, **in that** the mounting head (9) can be moved between the component feeds (12) and the mounting region and **in that** removal locations (13) of the component feeds are arranged within the coverage region of the grippers (5).

16. Mounting device according to Claim 15, **characterized in that** the mounting device is provided with at least two mounting heads (9) which can be moved independently of one another.

17. Mounting device according to Claim 16, **characterized in that** the mounting heads (9) can be moved in a common driving and guiding system.

## Revendications

1. Dispositif d'équipement pour équiper des supports de composants (4) avec des composants électriques (6) au moyen d'au moins une tête d'équipement qui est constituée d'un soutien (2) déplaçable par rapport au support de composants (4) et d'au moins un support (3) logé mobile sur ce soutien et destiné à une pluralité de préhenseurs (5) pour les composants (6), les préhenseurs (5) étant conçus de préférence comme des pipettes aspirantes,
le soutien (2) comprenant au moins un poste de traitement pour les composants (6) devant lequel les préhenseurs (5) peuvent être déplacés, chacun des préhenseurs (5) étant logé dans le support (3) de manière à pouvoir tourner autour d'un axe central particulier,
au moins le préhenseur (5) qui se trouve dans une position de pose pouvant être descendu le long de son axe de rotation vers le support de composants (4) et
la tête d'équipement étant munie de moyens d'entraînement pour la translation et pour la rotation des préhenseurs (5),
**caractérisé en ce que**, sur le support mobile (3), il est associé à chacun des préhenseurs (5) un entraînement en translation (8) autonome et commandable individuellement pour faire descendre le préhenseur (5).

2. Dispositif d'équipement selon la revendication 1, **caractérisé en ce qu'**il est associé à chacun des préhenseurs (5) un entraînement en rotation particulier.

3. Dispositif d'équipement selon la revendication 2, **caractérisé en ce que** l'entraînement en translation (8) et l'entraînement en rotation sont réunis en une unité d'entraînement combinée qui comprend une pluralité d'aimants qui sont répartis de manière concentrique et qui sont disposés sur plusieurs anneaux situés axialement les uns au-dessus des autres.

4. Dispositif d'équipement selon l'une des revendications 1 à 3, **caractérisé en ce que** les préhenseurs (5) sur le support (3) sont disposés sur plusieurs rangées par rapport à leur mouvement relatif par rapport au soutien (2).

5. Dispositif d'équipement selon la revendication 4, **caractérisé en ce qu'**il est associé à chacune des rangées au moins l'un des postes de traitement (par exemple 7).

6. Dispositif d'équipement selon la revendication 4, **caractérisé en ce que** le poste de traitement détecte au moins deux rangées de préhenseurs.

7. Dispositif d'équipement selon la revendication 6, **caractérisé en ce que** l'un des postes de traitement est conçu comme un poste optique (7) pour la détection de la position des composants (6) sur le préhenseur (5), que le champ visuel du poste optique (7) couvre au moins deux rangées de préhenseurs et qu'un dispositif d'évaluation relié au poste optique (7) évalue séparément les zones visibles associées aux différentes rangées de préhenseurs.

8. Dispositif d'équipement selon l'une des revendications précédentes, **caractérisé en ce que** le support de type revolver (3) est logé sur le soutien (2) de manière à pouvoir tourner.

9. Dispositif d'équipement selon la revendication 8, **caractérisé en ce que** le soutien (2) est logé sur le dispositif d'équipement de manière à pouvoir se déplacer dans au moins une direction d'un système de coordonnées.

10. Dispositif d'équipement selon la revendication 9, **caractérisé en ce que** l'axe de rotation du support (3) est dirigé parallèlement à la surface de pose du support de composants (4) et que les préhenseurs (5) sont disposés à une certaine distance radiale sur le support (3) dans au moins un plan de rotation.

11. Dispositif d'équipement selon la revendication 9, **caractérisé en ce que** l'axe de rotation du support est incliné par rapport à la surface de pose et que les préhenseurs sont disposés répartis en cône sur le support.

12. Dispositif d'équipement selon la revendication 8 ou 9, **caractérisé en ce que** l'axe de rotation du support (11) est perpendiculaire à la surface de pose et que des préhenseurs (5) perpendiculaires à la surface de pose sont disposés répartis en anneau sur le support (11).

13. Dispositif d'équipement selon la revendication 12, **caractérisé en ce que** les préhenseurs (5) sont disposés sur au moins deux anneaux de diamètres différents.

14. Dispositif d'équipement selon la revendication 12 ou 13, **caractérisé en ce que** le diamètre de l'anneau extérieur des préhenseurs (5) est au moins égal à la largeur d'une zone d'équipement du dispositif d'équipement, que le support de composants (4) ou la tête d'équipement (9) peut être déplacé sur le dispositif d'équipement perpendiculairement à cette première direction du système de coordonnées et que le support (3) peut être tourné précisément sur le soutien (2) dans une position angulaire dans laquelle le composant respectif (6) peut être posé sur le support de composants (4) à la première distance prédéterminée.

15. Dispositif d'équipement selon la revendication 14, **caractérisé en ce que** des amenées de composants (12) sont disposées dans le dispositif d'équipement à l'extérieur de la zone d'équipement, que le support de composants (4) peut être fixé temporairement dans une position définie sur le dispositif d'équipement, que la tête d'équipement (9) peut être déplacée entre les amenées de composants (12) et la zone d'équipement et que des points d'enlèvement (13) des amenées de composants sont disposés à l'intérieur de la zone de couverture des préhenseurs (5).

16. Dispositif d'équipement selon la revendication 15, **caractérisé en ce que** le dispositif d'équipement est muni d'au moins deux têtes d'équipement (9) qui peuvent être déplacées indépendamment l'une de l'autre.

17. Dispositif d'équipement selon la revendication 16, **caractérisé en ce que** les têtes d'équipement (9) peuvent être déplacées dans un système d'entraînement et de guidage commun.
